(19) Europäisches Patentamt
European Patent Office
Office européen des brevets

(11) **EP 4 083 152 B1**

(12) **EUROPEAN PATENT SPECIFICATION**

(45) Date of publication and mention
of the grant of the patent:
**18.02.2026 Bulletin 2026/08**

(21) Application number: **20905421.2**

(22) Date of filing: **19.11.2020**

(51) International Patent Classification (IPC):
*C09G 1/02* *(2006.01)*    *C09K 3/14* *(2006.01)*
*B24B 37/00* *(2012.01)*    *H01L 21/304* *(2006.01)*
*H01L 21/02* *(2006.01)*

(52) Cooperative Patent Classification (CPC):
**C09G 1/02; H10P 90/129**

(86) International application number:
**PCT/JP2020/043156**

(87) International publication number:
**WO 2021/131434 (01.07.2021 Gazette 2021/26)**

(54) **POLISHING COMPOSITION**

POLIERZUSAMMENSETZUNG

COMPOSITION DE POLISSAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.12.2019 JP 2019233278**

(43) Date of publication of application:
**02.11.2022 Bulletin 2022/44**

(73) Proprietor: **NITTA DuPont Incorporated Osaka-shi, Osaka 556-0022 (JP)**

(72) Inventor: **YAMASAKI, Tomoki Kyotanabe-shi, Kyoto 610-0333 (JP)**

(74) Representative: **Kuhnen & Wacker Patent- und Rechtsanwaltsbüro PartG mbB Prinz-Ludwig-Straße 40A 85354 Freising (DE)**

(56) References cited:
**EP-A1- 2 840 591       EP-A1- 2 858 096**
**EP-A1- 3 366 746       WO-A1-2018/124230**
**WO-A1-2019/131448     JP-A- 2002 075 928**
**JP-A- 2011 515 023     JP-A- 2014 036 206**
**JP-A- 2019 117 907     JP-A- H11 116 942**
**KR-A- 20100 067 952**

Remarks:
The file contains technical information submitted after the application was filed and not included in this specification

**Description**

TECHNICAL FIELD

The present invention relates to a polishing composition.

BACKGROUND ART

Ultra-precision machining is a very important technique in the manufacture of semiconductor products. With progressing miniaturization of LSI devices in recent years, there is a trend toward stricter requirements regarding the surface roughness and planarity of semiconductor wafers after precision polishing.

Traditionally, for primary polishing, stock removal has been the main focal point. However, it has been discovered that the surface quality of a semiconductor wafer after primary polishing affects the surface quality after secondary polishing and even final polishing. Accordingly, demands are expected to arise for achieving higher levels of wafer surface quality after primary polishing while maintaining current stock removal levels.

JP 2016-124943 A discloses a polishing composition containing polyvinyl alcohol-type water-soluble polymer and a piperazine compound that reduces the surface roughness of a wafer without reducing polishing rate. Moreover, the published patent applications WO 2019/131448 A1 and EP 2 840 591 A1 disclose polishing compositions according to the prior art.

PRIOR ART DOCUMENTS

PATENT DOCUMENTS

Patent Document 1: JP 2016-124943 A
Patent Document 2: WO 2019/131448 A1
Patent Document 3: EP 2 840 591 A1

SUMMARY OF THE INVENTION

PROBLEMS TO BE SOLVED BY THE INVENTION

For primary polishing of a 300 mm silicon wafer, double-side polishing is typically performed. For double-side polishing, a wafer held by a dedicated carrier is sandwiched by the upper and lower surface platens with a pad attached thereto, and then undergoes polishing. The carrier is made of SUS (i.e., stainless steel), titanium, or glass epoxy resin, for example.

For primary polishing, too, a water-soluble polymer may be included in the polishing composition to reduce the roughness of the silicon wafer. If double-side polishing is performed using a polishing composition containing a water-soluble polymer, friction between the carrier and polishing pad may cause vibration of the equipment. Increasing load or rotation speed to increase processing efficiency increases vibrations of the equipment, leading to a decrease in the quality of the silicon wafer or a failure of the equipment.

An object of the present invention is to provide a polishing composition that reduces vibrations of the equipment during polishing using a carrier made of glass epoxy resin.

MEANS FOR SOLVING THE PROBLEMS

A polishing composition according to an embodiment of the present invention includes: an abrasive; a load reducer, wherein the load reducer is polyethylene glycol alkyl ether (R-O-EO), glycerine fatty acid ester (R-CO-OR') or polypropylene glycol, wherein R is an alkyl group, EO is an ethylene oxy group, and R' is a glyceryl group; a water-soluble polymer; a basic compound; and water. The following expression is satisfied:

$$A \times B / C < 2.8,$$

where A is a contact angle of a 0.1 mass % aqueous solution of the load reducer relative to a surface of a glass epoxy resin plate with a surface roughness Ra of 3.0 nm measured using a contact angle measurement device as described below, B is a surface tension of a 0.1 mass % aqueous solution of the load reducer measured by a surface tension measurement device as described below, and C is a weight-average molecular weight of the load reducer measured by gel filtration chromatography.

EFFECTS OF THE INVENTION

The present invention provides a polishing composition that reduces vibrations of the equipment during polishing using a carrier made of glass epoxy resin.

EMBODIMENTS FOR CARRYING OUT THE INVENTION

The present inventors conducted various investigations to solve the above-identified problems. During the investigations, they examined polishing compositions including an abrasive, a water-soluble polymer, a basic compound and water and, in addition, a load reducer to reduce vibrations of the equipment while maintaining polishing performances. After extensive try-and-error, where they used various compounds to see whether they can be used as a load reducer, they found that a reduction in the load on the equipment is achieved if the expression

$$A \times B / C < 2.8$$

is satisfied, where A is the contact angle of a 0.1 mass % aqueous solution of the load reducer relative to a glass epoxy resin plate, B is the surface tension of the 0.1 mass % aqueous solution of the load reducer, and C is the molecular weight of the load reducer.

Although the mechanism at work can be estimated to be as follows, this is merely an estimate, and the scope of the present invention is not limited thereto. During double-side polishing, the friction between the carrier and pad and that between the workpiece and pad generate a polishing load. At this time, if a polishing composition containing a load reducer is present between the carrier and pad and between the workpiece and pad, the friction is reduced, which reduces a polishing load.

The smaller the contact angle A of the load reducer, the more easily the workpiece can be wetted. The smaller the surface tension B, the more easily the solution of the polishing composition can be delivered to the polishing system. Thus, it is believed that a polishing composition containing a load reducer with a smaller value of $A \times B$ is effectively fed to the polishing interface and is more likely to exhibit its load-reducing capability. If the molecular weight of the load reducer is small relative to $A \times B$, the effect of load reduction is believed to be small. It is believed that if the value of $A \times B$ of the load reducer is small and the load reducer has a sufficiently large molecular weight C relative to $A \times B$, or more specifically, if $A \times B / C < 2.8$, then, the effect of load reduction will be produced. From the viewpoint of the effect of load reduction, it is preferable if $A \times B / C \le 2.5$, and it is more preferable if $A \times B / C \le 2.1$. It is yet more preferable if $A \times B / C \le 1.7$, and it is still more preferable if $A \times B / C \le 1.1$. While no particular lower limit for $A \times B / C$ is to be specified, $0 < A \times B / C$ may be given.

The present invention was made based on these findings. Now, a composition for polishing a semiconductor according to an embodiment of the present invention will be described in detail.

A polishing composition according to an embodiment of the present invention includes: an abrasive; a load reducer; a water-soluble polymer; a basic compound; and water. The following expression is satisfied:

$$A \times B / C < 2.8,$$

where A is a contact angle of a 0.1 mass % aqueous solution of the load reducer relative to a surface of a glass epoxy resin plate with a surface roughness Ra of 3.0 nm, B is a surface tension of the aqueous solution, and C is a molecular weight of the load reducer.

The abrasive used may be one that is commonly used in this field. The abrasive may be silica, such as colloidal silica or fumed silica. The abrasive is not limited to any particular grain size, and may be one with a mean secondary particle size of 30 to 150 nm, for example.

The content of the abrasive is not limited to any particular value, and may account for 0.10 to 20 % by mass of the entire polishing composition, for example. To reduce polishing scratches and defects and/or residue on the polished silicon wafer, it is preferable that the abrasive content is as low as possible. On the other hand, if the polishing composition contains no abrasive at all, oxide film on the surface of the silicon wafer cannot be removed, for example. Prior to use, the polishing composition is diluted by a factor of 10 to 40 for polishing. The polishing composition of the present embodiment is preferably diluted, prior to use, such that the concentration of the abrasive is 100 to 5000 ppm (ppm by mass; the same applies hereinafter). There is a tendency that the higher the concentration of the abrasive, the less micro defects and/or haze. A lower limit for the concentration of the abrasive after dilution is preferably 1000 ppm, and more preferably 2000 ppm. An upper limit for the concentration of the abrasive after dilution is preferably 4000 ppm, and more preferably 3000 ppm.

The water-soluble polymer adheres to the surface of a workpiece, such as a semiconductor wafer, to modify the surface of the workpiece. This improves the uniformity of the polishing and reduces the surface roughness. Although not limiting, the water-soluble polymer may be a cellulose such as hydoxyethyl cellulose (HEC), hydroxyethylmethyl cellulose, hydroxypropyl cellulose, carboxymethyl cellulose, cellulose acetate, or methyl cellulose; a vinyl polymer such as polyvinyl alcohol (PVA), modified PVA (polyvinyl alcohol derivative), or polyvinylpyrrolidone (PVP); a glycoside; or a polyalcohol. Examples of glycosides include alkylene oxide derivatives of methylglucoside. Examples of alkylene oxide derivatives of methylglucoside include polyoxyethylenemethylglucoside and polyoxypropylenemethylglucoside.

The water-soluble polymer is preferably a polymer with no alkylene oxide group. Preferable ones of the above-listed water-soluble polymers are ones with higher molecular weights and with a structure that can easily take in water molecules: PVA or modified PVA are preferable, and HEC is more preferable.

If the water-soluble polymer is HEC, the molecular weight and content of HEC are not limited to any particular values; in some exemplary implementations, the molecular weight is not lower than 500,000 and not higher than 1.5 million, where the ratio of the mass percentage of the HEC relative to the mass percentage of the abrasive is not lower than 0.0075 and not higher than 0.025. The molecular weight of HEC is a weight-average molecular weight measured by GFC (gel filtration chromatography).

One of the above-listed water-soluble polymers may be used alone, or two or more thereof may be mixed and used.

Although not limiting, the content of the water-soluble polymer is 0.01 to 1.2 % by mass of the entire polishing composition (undiluted), for example.

The basic compound etches the surface of the semiconductor wafer for chemical polishing. That is, the basic compound is a polishing accelerator. The basic compound may be, for example, ammonia, an amine compound, an inorganic alkali compound, or the like. Basic compound means a compound that, when dissolved in water, exhibits basicity.

Examples of amine compounds include, for example, primary amines, secondary amines, tertiary amines, quaternary ammonium and hydroxides thereof, heterocyclic amines, and the like. Specific examples include tetramethylammonium hydroxide (TMAH), tetraethylammonium hydroxide (TEAH), tetrabutylammonium hydroxide (TBAH), methylamine, dimethylamine, trimethylamine, ethylamine, diethylamine, triethylamine, hexylamine, cyclohexylamine, ethylenediamine, hexamethylenediamine, diethylenetriamine (DETA), triethylenetetramine, tetraethylenepentamine, pentaethylenehexamine, monoethanolamine, diethanolamine, triethanolamine, N-($\beta$-aminoethyl)ethanolamine, anhydrous piperazine, piperazine hexahydrate, 1-(2-aminoethyl)piperazine, N-methylpiperazine, piperazine hydrochloride, guanidine carbonate, and the like.

Examples of inorganic alkali compounds include alkali metal hydroxides, alkali metal salts, alkaline earth metal hydroxides, and alkaline earth metal salts. Specific examples of inorganic alkaline compounds include potassium hydroxide, sodium hydroxide, potassium hydrogencarbonate, potassium carbonate, sodium hydrogencarbonate, sodium carbonate, and the like.

One of the above-listed basic compounds may be used alone, or two or more thereof may be mixed and used. Among the above-listed basic compounds, at least one selected from the group consisting of ammonia, an amine compound, an alkali metal hydroxide, and an alkali metal carbonate is particularly preferable.

The content of the basic compound (when two or more basic compounds are contained, their total amount) is not limited to any particular value, and may be such that the mass ratio between the abrasive and the basic compound is 1:0.001 to 1:0.10, for example. Prior to use, the polishing composition according to the present embodiment is preferably diluted such that the concentration of the basic compound is in a range of 5 to 200 ppm.

The load reducer has such physical properties that the contact angle A and surface tension B and the molecular weight of the load reducer C satisfy the following expression:

$$A \times B/C < 2.8.$$

The contact angle A is the contact angle of a 0.1 mass % aqueous solution of the load reducer relative to the surface of a glass epoxy resin plate with a surface roughness Ra of 3.0 nm. The surface tension B is the surface tension of a 0.1 mass % aqueous solution of the load reducer. The molecular weight C of the load reducer is a weight-average molecular weight measured by GFC.

The polishing composition according to the present embodiment may be used as a polishing agent when, for example, a semiconductor substrate is held by a carrier made of glass epoxy resin and polished. As the polishing composition contains a load reducer having the above-identified properties, vibrations of the equipment can be reduced during polishing.

The load reducer is a polymer having an ether bond (ether linkage). The polishing composition includes, in addition to the above-discussed water-soluble polymer for reducing the surface roughness of the object being polished,

EP 4 083 152 B1

one or more polymers acting as the load reducer.

A polymer used as the load reducer is a polymer that includes, in addition to an ether bond, an alkyl group (R), ethylene oxy group (EO) or glyceryl group (R'), namely polyethylene glycol alkyl ether (R-O-EO) or glycerine fatty acid ester (R-CO-OR'). Alternatively, the load reducer is a polymer including a propyl group and an ether bond, namely polypropylene glycol. The load reducer is a polymer including an ether bond and including a hydrophilic portion and a hydrophobic portion, where the contact angle A, surface tension B and molecular weight C satisfy the above expression.

The content of the load reducer in the polishing composition (undiluted) is not limited to any particular value, and may be 0.003 to 0.5 % by mass, for example.

The polishing composition includes water. The content of water is not limited to any particular value, and any appropriate amount may be included. It should be understood that, as discussed further below, in implementations where the polishing composition is prepared in the form of a high-concentration solution with a higher concentration than the desired level for use and is diluted prior to use, water may be added as a diluent during dilution.

The polishing composition according to the present embodiment may further include a pH controller. The pH of the polishing composition according to the present embodiment is preferably 8.0 to 12.0.

The polishing composition according to the present embodiment may include, in addition to the above, any ingredient(s) that is/are generally known in the field of polishing compositions.

The polishing composition according to the present embodiment is prepared by appropriately mixing the abrasive, water-soluble polymer, basic compound, load reducer, and other ingredients and then adding water. Alternatively, the polishing composition according to the present embodiment may be prepared by successively mixing with water the abrasive, water-soluble polymer, basic compound, load reducer, and other ingredients. These ingredients may be mixed by a means that is typically used in the technical field of polishing compositions, such as a homogenizer or ultrasonics.

The polishing composition described above is diluted with water to an appropriate concentration before being used to polish a semiconductor wafer.

The polishing composition according to the present embodiment is suitably used to polish of a semiconductor substrate from a silicon wafer (i.e., silicon substrate), for example. The polishing composition according to the present embodiment is particularly suitable for double-side polishing of a silicon wafer using a carrier of glass epoxy resin. Accordingly, such a composition for polishing a semiconductor substrate, and particularly a composition for polishing a silicon substrate, are embodiments of the present invention.

EXAMPLES

The present invention will now be described more specifically with reference to examples. The present invention is not limited to these examples.

[Polishing 1]

Polishing compositions were prepared by adding, to a base of the ingredients shown in Table 1, load reducers as shown in Table 2 (amount added: 0.005 % by mass) (Inventive Examples 1 to 6 and Comparative Examples 1 to 6). Further, polishing compositions labeled with Inventive Examples 7 to 9 shown in Table 3 were prepared. An amount (%) added shown in Table 3 is in mass percentage.

[Table 1]

|  | Abrasive | Basic Compound | Water-Soluble Polymer | |
| --- | --- | --- | --- | --- |
|  | Silica | Ammonia | HEC | Glycoside |
| Amount added in mass %) | 0.232% | 0.012% | 0.004% | 0.012% |

[Table 2]

|  |  | Load reducer | Contact angle A | Surface tension B | Molecular weight C | A×B/C | ΔCoF | Determination about ΔCoF | Tool noise / vibration |
| --- | --- | --- | --- | --- | --- | --- | --- | --- | --- |
| Inv. Ex. 1 |  | polyethylene glycol alkyl ether (R-O-EO) | 60 | 51 | 2800 | 1.1 | 0.17 | excellent | no |

5

(continued)

| | Load reducer | Contact angle A | Surface tension B | Molecular weight C | A×B/C | ΔCoF | Determination about ΔCoF | Tool noise / vibration |
|---|---|---|---|---|---|---|---|---|
| Inv. Ex. 2 | glycerin fatty acid ester | 61 | 46 | 1600 | 1.7 | 0.10 | excellent | no |
| Inv. Ex. 3 | glycerin fatty acid ester | 58 | 35 | 1100 | 1.8 | 0.03 | good | no |
| Inv. Ex. 4 | polypropylene glycol, triol type | 57 | 43 | 1500 | 1.6 | 0.03 | good | no |
| Inv. Ex. 5 | glycerin fatty acid ester | 60 | 36 | 1000 | 2.1 | 0.07 | good | no |
| Inv. Ex. 6 | glycerin fatty acid ester | 63 | 45 | 1100 | 2.5 | 0.04 | good | no |
| Comp. Ex. 1 | not added | 55 | 71 | - | - | 0.00 | poor | yes |
| Comp. Ex. 2 | polyethylene glycol alkyl ether (R-O-EO) | 55 | 47 | 500 | 5.2 | 0.01 | poor | ves |
| Comp. Ex. 3 | polyglycerin | 64 | 72 | 310 | 14.9 | 0.01 | poor | yes |
| Comp. Ex. 4 | polyglycerin | 71 | 72 | 500 | 10.2 | 0.00 | poor | yes |
| Comp. Ex. 5 | polyclycerin | 65 | 71 | 1500 | 3.1 | 0.00 | poor | yes |

[Table 3]

| | Abrasive | Basic Compound | Water-Soluble Polymer | | | Load Reducer | | | | | | | |
| | Silica | Ammonia | HEC | Modified PVA | Glycoside | Load reducer | Contact angle A | Surface tension B | Molecular weight C | A×B/C | ΔCoF | Determination about ACoF | Tool noise / vibration |
|---|---|---|---|---|---|---|---|---|---|---|---|---|---|
| Inv. Ex. 7 | 0.232% | 0.012% | 0.004% | | 0.012% | 0.005% | 44 | 54 | 6900 | 0.8 | 0.17 | excellent | no |
| Inv. Ex. 8 | 0.282% | 0.012% | | 0.004% | 0.012% | 0.005% | 44 | 54 | 6900 | 0.8 | 0.08 | good | no |
| Inv. Ex. 9 | 0.282% | 0.012% | 0.002% | 0.002% | 0.012% | 0.005% | 44 | 54 | 6900 | 0.8 | 0.14 | excellent | no |

EP 4 083 152 B1

The contact angle A of a load reducer was measured in the following manner: The contact angle A was measured using a contact angle measurement device (DM 500 automatic contact angle meter from Kyowa Interface Science Co., Ltd.). The contact angle A was calculated by allowing a 0.1 mass % aqueous solution of the load reducer to adhere to the surface of a glass epoxy resin plate, photographing it with a camera, and determining the contact angle between the substrate and aqueous solution by the θ/2 method. The surface roughness of the glass epoxy resin plate, Ra, was 3.0 nm. The surface roughness Ra was a surface roughness Ra measured by a Wyko NT9300 non-contact interference microscope from Veeco Instruments Inc. in the PSI mode with an viewing angle of 94 nm by 123 nm.

The surface tension B of the load reducer was measured in the following manner: The surface tension B was measured by a surface tension measurement device (DM 500 automatic contact angle meter from Kyowa Interface Science Co., Ltd.). The surface tension B was calculated by extruding a 0.1 mass % aqueous solution of the load reducer (solution temperature: 25 °C) through the tip of a vertically oriented thin pipe, photographing with a camera liquid drops hanging from the tip of the thin pipe, and using the pendant-drop method for calculation.

The molecular weight C of the load reducer was measured by GPC.

All of the amounts shown in Tables 1 to 3 are those before dilution (i.e., undiluted); the balance was water. The polishing composition for Comparative Example 1 did not contain a polymer constituting the load reducer. The colloidal silica used had a mean secondary particle size of 70 nm. The HEC used had a weight-average molecular weight of 500,000. The glycoside in Tables 1 and 3 was a polyoxyethylene methylglucoside with a weight-average molecular weight of 634. The modified PVA in Table 3 was butenediol vinyl alcohol polymer.

[Load Measurement Test 1]

The polishing compositions shown in Tables 1 and 2 and the polishing compositions shown in Table 3 were diluted by a factor of 41, and a POLI-762 polishing machine from G&P Technology, Inc. was used with a 12-inch glass epoxy resin plate as an object to be polished to perform friction analysis. The object to be polished was a glass epoxy resin plate in order to simulate friction conditions during double-side polishing using a carrier of glass epoxy resin. The polishing pad used was an EXTERION (registered trademark) SL-31 pad from Nitta Haas Incorporated. The feed rate of the polishing composition was 300 mL/min, the surface pressure was 150 g/cm$^2$, and the guide pressure was 220 g/cm$^2$. CoF was measured by the above-described polishing machine. CoF is the ratio of the horizontal force of the polishing head to the vertical load of the polishing head during polishing. The smaller the polishing load, the smaller CoF. ΔCoF is the difference between the CoF values before and after the addition of the load reducer. For example, ΔCoF in Table 2 indicates the difference between the CoF value during polishing under the above conditions using a base of the ingredients shown in Table 1, on the one hand, and the CoF value during polishing under the above conditions using a polishing composition with a base and, in addition, a load reducer shown in Table 2. It is believed that a ΔCoF value indicates the load reducer's effect of load reduction. An example with a ΔCoF value not smaller than 0.03 was determined to exhibit an effect of load reduction (indicated by "good" in Tables 2 and 3). An example with a ΔCoF value not smaller than 1.0 was determined to exhibit an excellent effect of load reduction (indicated by "excellent" in Tables 2 and 3).

[Load Measurement Test 2]

The polishing compositions shown in Tables 1 and 2 and the polishing compositions shown in Table 3 were diluted by a factor of 41, and a DSM20B-5P-4D machine from SpeedFam Company Limited was used to perform double-side polishing on a 12-inch silicon wafer. The polishing pad used was an EXTERION (registered trademark) SL-31 pad from Nitta Haas Incorporated. Polishing was performed for 3 minutes, and it was investigated whether there was tool noise/vibration.

For each of the load reducers for Inventive Examples 1 to 9 shown in Tables 2 and 3, the contact angle A, surface tension B and molecular weight C satisfied A×B/C < 2.8. Each of the polishing compositions containing these load reducers had a ΔCoF value not smaller than 0.03, which means that an effect of load reduction was produced. Further, for the examples with ΔCoF values not smaller than 0.03, no tool noise/vibration was observed.

The polishing composition for Comparative Example 1 had no load reducer added. As a result, for Comparative Example 1, no effect of load reduction was produced, and tool noise/vibration occurred.

For each of the polishing compositions for Comparative Examples 2 to 5, the value of A×B/C of the load reducer was not smaller than 2.8. As a result, for Comparative Examples 2 to 5, no effect of load reduction was produced, and tool noise/vibration occurred.

Inventive Examples 7 to 9 shown in Table 3 had the same load reducer added. That is, the value of A×B/C in every one of the load reducers for Inventive Examples 7 to 9 was the same, i.e., 0.3. Inventive Examples 7 to 9 had water-soluble polymers with different structures. For Inventive Example 7, the water-soluble polymer contained HEC in addition to glycoside. For Inventive Example 8, the water-soluble polymer contained modified PVA in addition to glycoside. For Inventive Example 9, the water-soluble polymer contained HEC and modified PVA in addition to glycoside.

Every one of Inventive Examples 7 to 9 had a ΔCoF value not smaller than 0.08, which means that an effect of load reduction was produced. Moreover, no tool noise/vibration was observed. Each of Inventive Examples 7 and 9, having a water-soluble polymer containing HEC, had a larger ΔCoF value and a greater effect of load reduction than Inventive Example 8, which contained no HEC.

Embodiments of the present invention have been described. The above-described embodiments are merely illustrative examples useful for carrying out the present invention. As such, the present invention is not limited to the above-described embodiments.

**Claims**

1. A polishing composition comprising:

   an abrasive;
   a load reducer, wherein the load reducer is polyethylene glycol alkyl ether (R-O-EO), glycerine fatty acid ester (R-CO-OR') or polypropylene glycol, wherein R is an alkyl group, EO is an ethylene oxy group, and R' is a glyceryl group;
   a water-soluble polymer;
   a basic compound; and
   water,
   wherein the following expression is satisfied:

$$A \times B/C < 2.8,$$

   where A is a contact angle of a 0.1 mass % aqueous solution of the load reducer relative to a surface of a glass epoxy resin plate with a surface roughness Ra of 3.0 nm measured using a contact angle measurement device as described in the description, B is a surface tension of a 0.1 mass % aqueous solution of the load reducer measured by a surface tension measurement device as described in the description, and C is a weight-average molecular weight of the load reducer measured by gel filtration chromatography.

2. The polishing composition according to claim 1, wherein the water-soluble polymer is hydoxyethyl cellulose.

**Patentansprüche**

1. Polierzusammensetzung, umfassend:

   ein Schleifmittel;
   einen Lastreduzierer, wobei der Lastreduzierer Polyethylenglykolalkylether (R-O-EO), Glycerinfettsäureester (R-CO-OR') oder Polypropylenglykol ist,
   wobei R eine Alkylgruppe ist, EO eine Ethylenoxygruppe ist und R' eine Glycerylgruppe ist;
   ein wasserlösliches Polymer;
   eine basische Verbindung; und
   Wasser,
   wobei die folgende Beziehung erfüllt ist:

$$A \times B/C < 2{,}8,$$

   wobei A ein Kontaktwinkel einer 0,1-Masseprozent-wässrigen Lösung des Lastreduzierers ist, zu einer Oberfläche einer Glas-Epoxidharzplatte mit einer Oberflächenrauheit Ra von 3,0 nm ist, gemessen unter Verwendung einer Kontaktwinkelmessvorrichtung, wie in der Beschreibung beschrieben, B eine Oberflächenspannung einer 0,1-Masseprozent-Wasserlösung des Lastreduzierers ist, gemessen mit einer Oberflächenspannungsmessvorrichtung, wie in der Beschreibung beschrieben, und C ein gewichtsmittleres Molekulargewicht des Lastreduzierers ist, gemessen durch Gelfiltrationschromatographie.

2. Die Polierzusammensetzung nach Anspruch 1, wobei das wasserlösliche Polymer Hydroxyethylcellulose ist.

**Revendications**

1. Une composition de polissage comprenant :

   un abrasif ;
   un réducteur de charge, dans lequel le réducteur de charge est un éther alkylique de polyéthylène glycol (R-O-EO), un ester d'acide gras de glycérine (R-CO-OR') ou un polypropylène glycol, dans lequel R est un groupe alkyle, EO est un groupe éthylène oxy et R' est un groupe glycéryle ;
   un polymère hydrosoluble ;
   un composé basique ; et
   de l'eau,
   dans laquelle l'expression suivante est satisfaite :

$$A \times B/C < 2,8,$$

   où A est un angle de contact d'une solution aqueuse à 0,1 % en masse du réducteur de charge par rapport à une surface d'une plaque de résine époxy de verre ayant une rugosité de surface Ra de 3,0 nm mesurée à l'aide d'un dispositif de mesure d'angle de contact tel que décrit dans la description, B est une tension superficielle d'une solution aqueuse à 0,1 % en masse du réducteur de charge mesurée à l'aide d'un dispositif de mesure de la tension superficielle tel que décrit dans la description, et C est un poids moléculaire moyen en poids du réducteur de charge mesuré par chromatographie par filtration sur gel.

2. La composition de polissage selon la revendication 1, dans laquelle le polymère hydrosoluble est l'hydroxyéthylcellulose.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016124943 A
- WO 2019131448 A1
- EP 2840591 A1